# EUROPEAN PATENT APPLICATION

(11) **EP 3 550 627 A1**
(43) Date of publication of application: **09.10.2019**
(21) Application number: 17849859.8
(22) Date of filing: 14.09.2017
(51) Int. Cl.: H01L 51/52, H01L 27/32

(54) **DISPLAY DEVICE**

(30) Priority: 01.12.2016 CN 201621310187 U
(71) Applicant: BOE Technology Group Co., Ltd., Beijing 100015 (CN)
(72) Inventor: ZHANG, Yuxin, Beijing 100176 (CN); CHENG, Hongfei, Beijing 100176 (CN); WU, Xinyin, Beijing 100176 (CN); QIAO, Yong, Beijing 100176 (CN)
(74) Representative: Cohausz & Florack
(86) International application number: PCT/CN2017/101720
(87) International publication number: WO 2018/099158

(57) **Abstract**

Provided is a display apparatus, belonging to the field of display technology. The display apparatus includes: a base substrate, which includes a main panel region and a peripheral region surrounding the main panel region; a display structure, which is arranged on the base substrate and positioned in the main panel region; a circuit structure, which is arranged in the peripheral region, for controlling driving of the display structure; and a circuit package, which packages the circuit structure. The display apparatus prolongs the service lives of the devices in the circuit structure, thereby prolonging the service life of the display device and also avoiding the occurrence of poor display of the display apparatus due to the damage of the circuit structure.

## Description

### Cross-reference to Related Application

The present application claims priority to Chinese Patent Application No. 201621310187.6 filed on December 1, 2016, entitled "DISPLAY APPARATUS", the disclosure of which is hereby incorporated by reference in its entirety.

### Technical Field

The present disclosure relates to the field of display technology, and particularly relates to a display apparatus.

### Background

Silicon-based organic light emitting diode microdisplay apparatus is widely used, and is especially applicable to a helmet mounted display, a stereoscopic display and a spectacle display etc.

### Summary

The present disclosure is directed to solve at least one of existing problems in the related art and provides a display apparatus.

In order to achieve the above object, in an aspect, provided is a display apparatus including: a base substrate, which includes a main panel region and a peripheral region surrounding the main panel region; a display structure, which is arranged on the base substrate and positioned in the main panel region; a circuit structure, which is arranged in the peripheral region, for controlling driving of the display structure; and a circuit package, which packages the circuit structure.

In some embodiments, the display apparatus includes a plurality of circuit structures which are arranged on both sides of the main panel region respectively.

In some embodiments, the display apparatus includes a plurality of circuit packages corresponding to the plurality of circuit structures on a one-to-one basis.

In some embodiments, the display apparatus further includes a circuit backboard, which is arranged on a surface of the base substrate distal to the circuit structure.

In some embodiments, the circuit package further packages the circuit backboard.

In some embodiments, the base substrate includes a silicon substrate and a silicon-based driving circuit arranged on a surface of the silicon substrate facing the display structure, the display apparatus further includes a planarization layer, which is arranged on a surface of the silicon-based driving circuit distal to the silicon substrate and the circuit structure is arranged on the planarization layer.

In some embodiments, the display apparatus further includes a package cover plate, which is arranged on a side of the display structure distal to the base substrate, and the circuit package further packages the package cover plate.

In some embodiments, the circuit package packages an upper surface of the package cover plate.

In some embodiments, the circuit package packages side-end faces of the package cover plate and a top surface of the circuit package is flush with the upper surface of the package cover plate.

In some embodiments, the circuit package packages a lower surface of the package cover plate.

In some embodiments, the display apparatus further includes a package layer, which is arranged between the package cover plate and the display structure, for packaging the display structure and the planarization layer together.

In some embodiments, the display structure includes an organic light emitting diode display panel.

In some embodiments, the circuit structure includes a driving control circuit for controlling display of the display structure.

In some embodiments, the circuit package is made of resin.

In some embodiments, the circuit package is a multi-layered film structure.

In some embodiments, the multi-layered film structure is made of organic film.

In some embodiments, the multi-layered film structure is made of inorganic film.

In some embodiments, the multi-layered film structure is made of organic film and inorganic film arranged alternately.

In some embodiments, the material of the organic film is at least one selected from a group consisting of polyimide, polyurea, polyamides, polyesters, polyethylene and polypropylene.

In some embodiments, the material of the inorganic film is at least one selected from a group consisting of nano-silicon dioxide (SiOx), silicon nitride (SiNx), nitrogen-doped silicon carbide (SiCxNy), silicon oxynitride (SiOxNy), alumina (AlOx), tin oxide (SnO₂), aluminum nitride (AlN), magnesium fluoride(MgF₂), calcium fluoride (CaF₂), indium oxide (In₂O₃) and indium tin oxide (ITO).

In the display apparatus provided by the present disclosure, the circuit structure located in the peripheral region of the base substrate is packaged by providing the circuit package so as to prevent the circuit structure in the peripheral region from being damaged due to long-term contact with water and oxygen, prolonging the service lives of the devices in the circuit structure, thereby prolonging the service life of the display device and also avoiding the occurrence of poor display of the display apparatus due to the damage of the circuit structure.

### Brief Description of the Drawings

The accompanying drawings are used to provide a further understanding of the present disclosure and constitute a part of the specification. The accompanying drawings, together with the following specific embodiments, are used to explain the present disclosure, but not intended to limit the present disclosure. In the drawings:
Fig. 1 is a schematic structural diagram of a first embodiment of a display apparatus according to the present disclosure;
Fig. 2 is a schematic structural diagram of a second embodiment of the display apparatus according to the present disclosure;
Fig. 3 is a schematic structural diagram of a third embodiment of the display device according to the present disclosure;
Fig. 4 is a schematic structural diagram of a fourth embodiment of the display device according to the present disclosure.

### Reference signs:

10-base substrate; 101- main panel region; 102-peripheral region; 103-silicon substrate; 104-silicon-based driving circuit; 11- display structure; 111- anode; 112-organic light emitting layer; 113- cathode; 12-circuit structure; 13-circuit package; 14-circuit backboard; 15- planarization layer; 16- package cover plate; 17- package layer.

### Detailed Description

Embodiments of the present disclosure will be described in detail in conjunction with the drawings. It should be understood that the embodiments described herein are only used for describing and explaining the present disclosure, but not for limiting the present disclosure.

It should be noted that the terms "up", "down" and the like mentioned in the present disclosure refer to the "up" and "down" directions shown in the drawings.

In the field of display technology, a silicon-based organic light-emitting diode (OLED) microdisplay employs a monocrystalline silicon chip as a base and has a pixel size of one tenth that of a conventional display device, therefore its fidelity is much higher than that of conventional display devices. However, for the current silicon-based organic light-emitting diode microdisplays, generally, only the light-emitting region of the organic light-emitting diode is packaged without packaging the peripheral region surrounding the light-emitting region, making the circuits arranged in the peripheral region to be exposed to water and air for a long time, thus damage to the circuits is prone to be caused, resulting in problems such as poor display.

Therefore, how to make the circuits in the periphery around the light-emitting region of the display apparatus employing the silicon-based organic light-emitting diode microdisplays in the related art undamaged becomes a problem to be solved urgently.

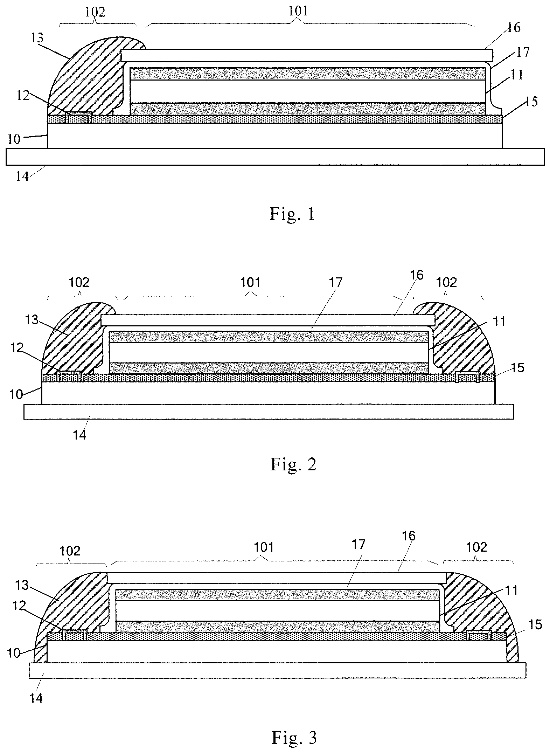

In an aspect, the present disclosure provides a display apparatus, as shown in Fig. 1, which includes a base substrate 10 and a display structure 11 arranged on the base substrate 10, wherein the base substrate 10 includes a main panel region 101 and a peripheral region 102 surrounding the main panel region 101, and the display structure 11 is positioned in the main panel region 101. The peripheral region 102 is provided therein with a circuit structure 12, for example, the circuit structure 12 may be a peripheral driving controlling circuit for controlling the display structure to display. The display apparatus further includes a circuit package 13, which packages the circuit structure 12 to the base substrate 10.

In the display apparatus provided by the present disclosure, the circuit structure located in the peripheral region of the base substrate is packaged by providing the circuit package so as to prevent the circuit structure in the peripheral region from being damaged due to long-term contact with water and oxygen, prolonging the service lives of the devices in the circuit structure, thereby prolonging the service life of the display device and also avoiding the occurrence of poor display of the display apparatus due to the damage of the circuit structure.

Specifically, in the display apparatus shown in Fig. 1, the circuit structure 12 is arranged in the peripheral region 102 of the base substrate 10, and the circuit structure 12 is covered by the circuit package 13 so that the circuit structure 12 cannot contact water and oxygen, in this way, the circuit structure 12 will not be damaged due to the water and oxygen, thus prolonging the service lives of the devices in the circuit structure 12.

As a specific implementation of the circuit package 13, the circuit package 13 may be formed as a sealing structure, for example, the circuit package 13 may be formed of resin, or the circuit package 13 may be formed as a sealing multi-layered film structure, the multi-layered film structure may be formed of an organic or inorganic film.

In a case that the circuit package 13 is formed into the multi-layered film structure, the multi-layered film structure may be a multi-layered organic film structure, a multi-layered inorganic film structure, or alternatively, a multi-layered alternating stack structure formed by alternately stacking the organic film and the inorganic film. In the formation of the circuit package 13 by alternately stacking the organic film and the inorganic film, an inorganic film may be formed first, and then an organic film may be formed on the inorganic film by a coating method, followed by coating another inorganic film on the organic film by a coating method, and so on, till a desired alternating stack structure is formed. The coating method is simple and easy to be implemented, thus not only ensuring good package performance of the circuit package 13, but also simplifying the process and reducing the cost.

In some implementations, the material of the organic film may be at least one selected from a group consisting of polyimide, polyurea, polyamic acid, polyester, polyethylene and polypropylene; the material of the inorganic film may be at least one selected from a group consisting of nano-silicon dioxide (SiOx), silicon nitride (SiNx), nitrogen-doped silicon carbide (SiCxNy), silicon oxynitride (SiOxNy), alumina (AlOx), tin oxide (SnO₂), aluminum nitride (AlN), magnesium fluoride(MgF₂), calcium fluoride (CaF₂), indium oxide (In₂O₃) and indium tin oxide (ITO). It can be easily understood that, when the material of the inorganic film is indium tin oxide, an insulating material layer should be arranged between the inorganic film of indium tin oxide and the circuit structure.

In addition, each of the above films can be prepared by at least one of sputtering method, thermal evaporation method, chemical vapor deposition method, plasma chemical vapor deposition method, ion beam assisted deposition method and atomic layer deposition method.

As a specific implementation, the display apparatus includes a plurality of circuit structures 12 respectively arranged in parts of the peripheral region 102 on both sides of the main panel region 101.

For example, as shown in Fig. 2, the display apparatus includes two circuit structures 12 respectively arranged in parts of the peripheral region 102 on both sides of the main panel region 101.

It can be understood that, in order to cater for the diversified functions of the display apparatus, the display apparatus may include a plurality of circuit structures 12 as required, and the circuit structures 12 may be all arranged in the peripheral region 102. The peripheral region 102 surrounds the main panel region 101 of the display apparatus, when the display apparatus includes a plurality of circuit structures 12, the plurality of circuit structures 12 are generally uniformly arranged on both sides of the main panel region 101 for facilitating the layout of the circuit structures 12. For example, the plurality of circuit structures 12 are respectively arranged in parts of the peripheral region 102 on both sides of the main panel region 101. In this embodiment, one circuit package 13 may be provided for circuit structure(s) 12 located on one side of the main panel region 101, and accordingly, the circuit packages 13 corresponding to the circuit structures 12 located on both sides of the main panel region 101 are arranged on both sides of the main panel region 101 and respectively package the circuit structures 12 on the base substrate 10 on both sides of the main panel region 101. The display apparatus shown in Fig. 1 is an implementation in which the circuit structure 12 is located in the peripheral region 102 on one side of the main panel region 101. The display apparatus shown in Fig. 2 is an implementation in which the circuit structures 12 are located in parts of the peripheral region 102 on both sides of the main panel region 101. As another specific implementation of the display apparatus, as shown in Fig. 1 to Fig. 4, the display apparatus further includes a circuit backboard 14 arranged on a surface of the base substrate 10 distal to the circuit structure 12 .

Specifically, in the direction shown in the drawings, the circuit backboard 14 is arranged on the lower surface of the base substrate 10.

In some implementations, the circuit backboard 14 is a printed circuit board. As can be seen from the drawings, the circuit backboard 14 is located at the bottom of the display apparatus, therefore, the circuit backboard 14 needs to have good supporting performance, and the printed circuit board has the advantage of high hardness and thus can be preferably used as the circuit backboard 14. In addition, wirings on the circuit backboard 14, which is a printed circuit board, are electrically connected with a silicon substrate and a silicon-based driving circuit (described later) provided in the base substrate to provide electric signals thereto. The printed circuit board also has the advantages of high wiring density and light weight.

As a specific implementation of the circuit package 13, in order to make the packaging of the circuit structure 12 firmer and tighter, a part of the circuit package 13 is in contact with and bonded to the circuit backboard 14, that is, the circuit package 13 further packages the circuit board 14.

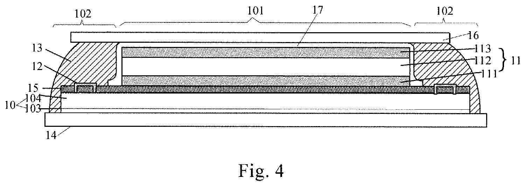

Specifically, as shown in Fig. 3 and Fig. 4, a portion of the bottom of the circuit package 13 is in contact with and bonded to the circuit backboard 14 (i.e., the circuit package 13 packages the circuit backplane 14), and another portion of the bottom of the circuit package 13 is in contact with and bonded to the base substrate 10 (i.e., the circuit package 13 packages the base substrate 10), so that the circuit structure 12 can be covered more completely, the package has good sealing performance and the package is also firmer.

As a specific implementation of the base substrate 10, as shown in Fig. 4, the base substrate 10 includes a silicon substrate 103 and a silicon-based driving circuit 104 arranged on a surface of the silicon substrate 103 facing the display structure 11. The display apparatus further includes a planarization layer 15 arranged on a surface of the silicon-based driver circuit 104 distal to the silicon substrate 103, and the circuit structure 12 is arranged on the planarization layer 15

It can be understood that, taking the direction shown in the drawing as an example, the silicon-based driving circuit 104 is arranged on the upper surface of the silicon substrate 103, a planarization layer 15 is arranged on the upper surface of the silicon-based driving circuit 104, and the planarization layer 15 is provided with a via hole through which the circuit structure 12 is connected to the silicon-based driving circuit 104 located below the planarization layer 15.

It should be noted that, since the silicon-based microdisplay apparatus is widely used and the silicon-based microdisplay apparatus includes the circuit structures 12 having various functions, in a case where the circuit packages 13 is used in the silicon-based microdisplay apparatus, it can effectively protect the circuit structures 12 arranged on the base substrate 10 and effectively increase the service life of the silicon-based microdisplay apparatus.

As still another specific implementation of the display apparatus, as shown in Fig. 1 to Fig. 4, the display apparatus includes a package cover plate 16 arranged on a side of the display structure 11 distal to the base substrate 10, the top of the circuit package 13 is in contact with and bonded to the package cover plate 16, in other words, the circuit package 13 also packages the package cover plate 16. The circuit package 13 and the package cover plate 16 can package the display apparatus well, protect the display apparatus better, and effectively improve the service life of the silicon-based display apparatus.

Specifically, as shown in Fig. 1, the package cover plate 16 is arranged on the upper surface of the display structure 11. A package layer 17 is arranged between the package cover plate 16 and the display structure 11. The package material used for the package layer 17 can be silica gel or other materials that can be used for packaging. Alternatively, the package layer 17 may also be made of glass glue, wherein glass powder is sintered by using a laser melting method. The package layer 17 packages the display structure 11 and the planarization layer 15 together.

In order to further stabilize the package of the circuit package 13, as an alternative embodiment, as shown in Fig. 1 and Fig. 2, the top of the circuit package 13 is brought into contact with and bonded to the upper surface of the package cover plate 16, that is, the upper surface of the package cover 16 is packaged by the top of the circuit package 13.

Specifically, as shown in Fig. 1 and Fig. 2, the bottom of the circuit package 13 packages the base substrate 10, wherein the top of the circuit package 13 packages the upper surface of the package cover plate 16. It can be understood that the bottom of the circuit package 13 can also have other packaging methods. For example, a portion of the bottom of the circuit package 13 packages a portion of the circuit backboard 14 and another portion of the bottom of the circuit package 13 packages the base substrate 10, i.e., the bottom of the circuit package 13 can package in a manner as shown in Fig. 3 and Fig. 4.

In order to further stabilize the package of the circuit package 13, as a second alternative embodiment, as shown in Fig. 3, the top of the circuit package 13 packages the side-end face of the package cover plate 16 and the top surface of the circuit package 13 is flush with the upper surface of the package cover plate 16.

Specifically, as shown in Fig. 3, the manner in which the top of the circuit package 13 packaging the package cover plate 16 is different from those as shown in Fig. 1 and Fig. 2 in that: the upper surface of the top of the circuit package 13 is flush with the upper surface of the package cover plate 16, and a portion of the bottom of the circuit package 13 shown in Fig. 3 packages the circuit backboard 14 and another portion thereof packages the base substrate 10. It can be understood that, in a case where the top of the circuit package 13 adopts the packaging manner as shown in Fig. 3, the bottom of the circuit package 13 may further adopt the packaging manner in which the circuit package 13 packages the base substrate 10 as shown in Fig. 1 and Fig. 2.

In order to further stabilize the package of the circuit package 13, as a third alternative implementation, as shown in Fig. 4, the top of the circuit package 13 packages a lower surface of the package cover plate 16.

Specifically, as shown in Fig. 4, a portion of the bottom of the circuit package 13 packages the circuit backboard 14 and another portion thereof packages the base substrate 10, and the top of the circuit package 13 packages the lower surface of the package cover plate 16. It can be understood that, in a case where the top of the circuit package 13 adopts the packaging manner shown in Fig. 4, the bottom of the circuit package 13 can further adopt the packaging manner in which the circuit package 13 packages the base substrate 10 as shown in Fig. 1 and Fig. 2.

As a specific implementation of the display structure 11, the display structure 11 includes an organic light emitting diode display panel.

Specifically, as shown in Fig. 4, the organic light emitting diode display panel includes an anode 111, an organic light emitting layer 112 and a cathode 113 provided in an order from bottom to top.

In the display apparatus provided by the present disclosure, the circuit structure located in the peripheral region of the base substrate is packaged by providing the circuit package so as to prevent the circuit structure in the peripheral region from being damaged due to long-term contact with water and oxygen, prolonging the service lives of the devices in the circuit structure, thereby prolonging the service life of the display device and also avoiding the occurrence of poor display of the display apparatus due to the damage of the circuit structure.

It should be understood that, the foregoing embodiments are only exemplary embodiments used for explaining the principle of the present disclosure, but the present disclosure is not limited thereto. Various variations and improvements may be made by a person skilled in the art without departing from the spirit and essence of the present disclosure, and these variations and improvements also fall into the protection scope of the present disclosure.

## Claims

1. A display apparatus, comprising:
a base substrate, which comprises a main panel region and a peripheral region surrounding the main panel region;
a display structure, which is arranged on the base substrate and positioned in the main panel region;
a circuit structure, which is arranged in the peripheral region, for controlling driving of the display structure; and
a circuit package, which packages the circuit structure.

2. The display apparatus of claim 1, wherein a plurality of circuit structures are provided and are arranged on both sides of the main panel region respectively.

3. The display apparatus of claim 2, wherein a plurality of circuit packages corresponding to the plurality of circuit structures on a one-to-one basis are provided.

4. The display apparatus of any one of claims 1 to 3, further comprising a circuit backboard, which is arranged on a surface of the base substrate distal to the circuit structure.

5. The display apparatus of claim 4, wherein the circuit package further packages the circuit backboard.

6. The display apparatus of any one of claims 1 to 3, wherein the base substrate comprises a silicon substrate and a silicon-based driving circuit arranged on a surface of the silicon substrate facing the display structure, the display apparatus further comprises a planarization layer, which is arranged on a surface of the silicon-based driving circuit distal to the silicon substrate and the circuit structure is arranged on the planarization layer.

7. The display apparatus of any one of claims 1 to 3, further comprising a package cover plate, which is arranged on a side of the display structure distal to the base substrate, and the circuit package further packages the package cover plate.

8. The display apparatus of claim 7, wherein the circuit package packages an upper surface of the package cover plate.

9. The display apparatus of claim 7, wherein the circuit package packages side-end faces of the package cover plate and a top surface of the circuit package is flush with the upper surface of the package cover plate.

10. The display apparatus of claim 7, wherein the circuit package packages a lower surface of the package cover plate.

11. The display apparatus of claim 7, further comprising a package layer, which is arranged between the package cover plate and the display structure, for packaging the display structure and the planarization layer together.

12. The display apparatus of any one of claims 1 to 3, wherein the display structure comprises an organic light emitting diode display panel.

13. The display apparatus of claim 12, wherein the circuit structure comprises a driving control circuit for controlling display of the display structure.

14. The display apparatus of any one of claims 1 to 3, wherein the circuit package is made of resin.

15. The display apparatus of any one of claims 1 to 3, wherein the circuit package is a multi-layered film structure.

16. The display apparatus of claim 15, wherein the multi-layered film structure is made of organic film.

17. The display apparatus of claim 15, wherein the multi-layered film structure is made of inorganic film.

18. The display apparatus of claim 15, wherein the multi-layered film structure is made of organic film and inorganic film arranged alternately.

19. The display apparatus of claim 16 or 18, wherein the material of the organic film is at least one selected from a group consisting of polyimide, polyurea, polyamides, polyesters, polyethylene and polypropylene.

20. The display apparatus of claim 17 or 18, wherein the material of the organic film is at least one selected from a group consisting of nano-silicon dioxide (SiOx), silicon nitride (SiNx), nitrogen-doped silicon carbide (SiCxNy), silicon oxynitride (SiOxNy), alumina (AlOx), tin oxide (SnO2), aluminum nitride (AlN), magnesium fluoride(MgF₂), calcium fluoride (CaF₂), indium oxide (In₂O₃) and indium tin oxide (ITO).
